# EUROPÄISCHE PATENTSCHRIFT

(11) **EP 1 797 641 B1**
(45) Veröffentlichungstag und Bekanntmachung des Hinweises auf die Patenterteilung: **30.07.2008**
(21) Anmeldenummer: 05801457.2
(22) Anmeldetag: 23.09.2005
(51) Int. Cl.: H03K 17/96, H03K 17/955

(54) **KAPAZITIVER ANN[HERUNGS- UND/ODER BER]HRUNGSSCHALTER**
CAPACITIVE PROXIMITY AND/OR TOUCH-SENSITIVE SWITCH
CAPTEUR DE PROXIMITE ET/OU DE CONTACT CAPACITIF

(30) Priorität: 29.09.2004 DE 102004047381; 25.02.2005 DE 102005008758
(43) Veröffentlichungstag der Anmeldung: 20.06.2007
(60) Teilanmeldung: 08002662.8
(73) Patentinhaber: BSH Bosch und Siemens Hausgeräte GmbH, 81739 München (DE)
(72) Erfinder: ROMANOWSKI, Hans-Jürgen, 93170 Bernhardswald (DE)
(86) Internationale Anmeldenummer: PCT/EP2005/054768
(87) Internationale Veröffentlichungsnummer: WO 2006/034993

(56) Entgegenhaltungen:
- EP-A- 0 858 166
- EP-A- 0 859 467
- DE-U1-7202005 002 15
- US-A- 4 458 293

## Beschreibung

Die Erfindung bezieht sich auf einen kapazitiven Annäherungs- und/oder Berührungsschalter, mit einem elektrisch leitfähigen Körper, der zwischen einer elektrisch isolierenden Abdeckplatte und einer im Abstand von dieser angeordneten Trägerplatte angeordnet und in Abstandsrichtung elastisch verformbar ist, wobei der elektrisch leitfähige Körper mit seinem oberen Ende an der Unterseite der Abdeckplatte anliegt und dort eine Sensorfläche bildet und wobei der elektrisch leitfähige Körper mit seinem unteren Ende mit einem elektrisch leitenden Kontakt der Trägerplatte verbunden ist.

Ein solcher kapazitiver Annäherungs- oder Berührungsschalter ist bereits aus US 5 892 652 A bekannt. Dort ist als elektrisch leitfähiger Körper eine Blattfeder vorgesehen, die in Form eines Z gebogen ist. Diese Blattfeder besteht aus einer Grundplatte, die auf der Trägerplatte befestigt ist und einer oberen Platte, die gegen die Unterseite der parallel zur Trägerplatte angeordneten Abdeckplatte gedrückt werden kann und dort die Sensorfläche bildet. Die Grundplatte und die obere Platte bilden die beiden Enden des Z, die durch ein mittleres, schräges Teil des Z miteinander verbunden sind. Durch dieses schräge Teil wird der Blattfeder derartig Flexibilität verliehen, dass Abweichungen in der Parallelität zwischen Trägerplatte und Abdeckplatte durch die Blattfeder ausgeglichen werden können. Eine solche Blattfeder hat allerdings den Nachteil, dass bei nicht vorhandener Flächenparallelität zwischen der Abdeckplatte und der oberen Platte der Blattfeder Luftzwischenräume zwischen der oberen Platte und der Unterseite der Abdeckplatte bestehen, so dass die Reaktionsempfindlichkeit des Berührungsschalters bei Berührungen der Oberseite der Abdeckplatte verringert ist. Ein weiterer Nachteil besteht darin, dass bei Variation des Abstands zwischen Abdeckplatte und Trägerplatte neben dem Abstand der oberen Platte zu der Grundplatte auch deren laterale Position zueinander variiert, so dass bei auf der Trägerplatte fixierter Grundplatte die Position der Sensorfläche an der Unterseite der Abdeckplatte je nach Abstand zwischen Abdeckplatte und Trägerplatte verschieden ist.

Die EP 0 858 166 A1 enthüllt eine ähnliche Feder, die den Abstand zwischen einer Leiterplatte und einer Abdeckplatte überbrückt, und an der Unterseite der Abdeckplatte eine Sensorfläche bildet.

Der vorliegenden Erfindung liegt daher die Aufgabe zugrunde, einen verbesserten kapazitiven Annäherungs- und/oder Berührungsschalter zur Verfügung zu stellen.

Gelöst wird die vorstehend aufgezeigte Aufgabe bei einem kapazitiven Annäherungsund/cder Berührungsschalter der eingangs genannten Art erfindungsgemäß durch die in Anspruch 1 genannten Merkmale.

Die Erfindung bringt den Vorteil mit sich, dass unterschiedliche Abstände zwischen der Abdeckplatte und der Trägerplatte mit der gewundenen Druckfeder überbrückt werden können, ohne dass sich die Position der Sensorfläche an der Unterseite der Abdeckplatte lateral verschiebt. Des weiteren können durch die gewundene Druckfeder neben Abweichungen in der Parallelität zwischen Trägerplatte und Abdeckplatte auch Unebenheiten der Unterseite der Abdeckplatte und Krümmungen der Abdeckplatte auf einfache Art und Weise ausgeglichen werden. Der gestreckte Körper ist bevorzugt ein Federdraht mit rundem oder rechteckigem Querschnitt, aus dem auf einfache Weise die Druckfeder gewickelt werden kann.

Die Druckfeder weist ein oberes Ende und ein dem oberen Ende gegenüberliegendes unteres Ende auf, wobei das obere Ende an der Abdeckplatte und das untere Ende an der Trägerplatte angeordnet ist. Zweckmäßigerweise weist die Druckfeder an ihrem oberen Ende zumindest eine an der Unterseite der Abdeckplatte anliegende obere Windung auf, die die Sensorfläche bildet. Insbesondere hat die obere Windung an mindestens drei Orten unmittelbaren mechanischen Kontakt zu der Unterseite der Abdeckplatte. Somit können unterschiedliche Formen der Sensorfläche auf einfachste Weise durch die Formgebung der oberen Windung ausgebildet werden.

Die Druckfeder weist an zumindest ihrem oberen Ende mindestens zwei Windungen auf, die spiralförmig in einer Ebene liegen. Dabei ist es gleichbedeutend, ob die Windungen von innen nach außen oder von außen nach innen gewickelt sind. Durch diese spiralförmig ineinander liegenden Windungen ist am oberen Ende der Druckfeder ein Windungsteller ausgebildet, der an der Unterseite der Abdeckplatte anliegt. Dieser Windungsteller ist in sich selbst derart elastisch, dass Unebenheiten der Unterseite der Abdeckplatte innerhalb der Fläche des Windungstellers mühelos ausgeglichen werden können. Durch die spiralförmig ineinander liegenden Windungen am unteren Ende der Druckfeder ist eine stabile Auflage der Druckfeder auf der Trägerplatte gewährleistet, wodurch die Druckfeder bei einem Bestückungsprozess der Trägerplatte leicht senkrecht zur Trägerplatte ausgerichtet werden kann.

Gemäß einer bevorzugten Ausführungsform steht die Druckfeder zwischen der Abdeckplatte und der Trägerplatte unter Druckspannung, und die Druckfeder weist an ihrem oberen Ende eine Form auf, die formschlüssig an die Unterseite der Abdeckplatte angepasst ist. Durch die Druckspannung wird insbesondere die obere Windung der Druckfeder an die Unterseite der Abdeckplatte angepresst, so dass ein formschlüssiger Kontakt entstehen kann. Am oberen Ende der Druckfeder ist durch mehrere spiralförmig in einer Ebene liegende Windungen ein Windungsteller ausgebildet. Dieser Windungsteller kann bei unter Druckspannung stehender Druckfeder seine Form an die Form der Unterseite der Abdeckplatte anpassen, so dass die oberen Windungen formschlüssig an der Unterseite der Abdeckplatte anliegen. Auf diese Weise kann auch bei gewölbten Abdeckplatten ein optimaler Kontakt zwischen der durch den Windungsteller gebildeten Sensorfläche und der Unterseite der Abdeckplatte hergestellt werden.

Zweckmäßigerweise ist die Druckfeder zumindest in einem oberen und/oder unteren Teilbereich derart keglig geformt, dass die Druckfeder Windungen mit unterschiedlichen Windungsdurchmessern aufweist. Dies bringt den Vorteil mit sich, dass bei Druckspannung mehrere Windungen spiralförmig in einer Ebene zuliegen kommen und sich auf diese Weise erst bei der unter Druckspannung stehenden Druckfeder ein Windungsteller ausbildet. Somit ist es nicht notwendig die Druckfeder, Insbesondere an ihrem oberen Ende, bereits von vorneherein mit einem Windungsteller auszubilden, sondern der Windungsteller bildet sich automatisch aus, sobald die Druckfeder unter Druckspannung zwischen Abdeckplatte und Trägerplatte montiert wird.

Gemäß einer bevorzugten Ausführungsform besteht in dem oberen Teilbereich und/oder unteren Teilbereich zwischen zumindest zwei benachbarten Windungen ein axialer Abstand in Richtung der axialen Federausdehnung, der im Bereich zwischen Null und einer Querschnittsflächenabmessung des gestreckten Körpers in Richtung der axialen Federausdehnung liegt, und ein radialer Abstand in Richtung der radialen Federausdehnung, der im Bereich zwischen einer und einer anderthalbfachen Querschnittsflächenabmessung des gestreckten Körpers in Richtung der radialen Federausdehnung liegt. Dabei wird der Abstand jeweils zwischen den mittleren Seelen der Windungen, z.B. den Mittelachsen des gestreckten Körpers, bestimmt. Durch diese eng nebeneinander liegenden Windungen, die insbesondere an dem oberen bzw. unteren Ende der Druckfeder angeordnet sind, wird ein Verhaken von mehreren gleichartigen Druckfedern miteinander bei einem automatisierten Bestückungsprozess der Trägerplatten verhindert bzw. reduziert, da der Abstand zwischen zwei Windungen geringer ist als die entsprechende Abmessung des gestreckten Körpers.

Zweckmäßigerweise ist die Druckfeder zumindest in einem Teilbereich zylindrisch geformt, wodurch ein Ausknicken der Druckfeder in diesem Teilbereich vermieden wird, sobald die Druckfeder bei der Montage zwischen Trägerplatte und Abdeckplatte unter Druck gesetzt wird.

Vorzugsweise weist der zylindrische Teilbereich zumindest an einem seiner Enden einen Unterteilbereich auf, in dem zwischen zumindest zwei aufeinanderfolgenden Windungen ein axialer Abstand in Richtung der axialen Federausdehnung besteht, der kleiner ist als zwei Querschnittsflächenabmessung des gestreckten Körpers in Richtung der axialen Federausdehnung. Auch hier wird der Abstand jeweils zwischen den zentralen Seelen der zwei benachbarten Windungen bestimmt. Durch diese eng nebeneinander liegenden Windungen kann ein Führungszylinder für ein Bestückungswerkzeug gebildet werden, so dass eine automatische Bestückung der Trägerplatte mit einer oder mehreren Druckfedern möglich ist.

Insbesondere ist der Unterteilbereich an einem Ende des zylindrischen Teilabschnitts angeordnet, an dem sich ein Bereich mit einem geringeren Windungsdurchmesser anschließt oder der ein Endabschnitt der Druckfeder an sich ist. Durch diese eng nebeneinander liegenden Windungen wird ein Verhaken von mehreren gleichartigen Druckfedern miteinander bei einem automatisierten Bestückungsprozess der Trägerplatten verhindert bzw. reduziert, da der Abstand zwischen zwei Windungen geringer ist als die entsprechende Abmessung des gestreckten Körpers.

Gemäß einer bevorzugten Ausführungsform ist die Druckfeder in einem ersten Teilbereich und in einem zweiten Teilbereich derart zylindrisch geformt, dass der erste Teilbereich einen von dem zweiten Teilbereich verschiedenen Windungsdurchmesser aufweist, und dass zwischen dem ersten Teilbereich und dem zweiten Teilbereich ein keglig geformter Übergangsbereich angeordnet ist. Bei einer maximalen Druckbelastung der Druckfeder können sich somit die beiden Teilbereiche ineinander verschieben, so dass der Teilbereich mit dem geringeren Windungsdurchmesser zumindest mit einem Teil seiner axialen Ausdehnung innerhalb des Teilbereichs mit dem größeren Windungsdurchmesser zu liegen kommt. Der auf diese Weise erzielte Federweg der Druckfeder ist gegenüber einem durch gleichmäßiges Anliegen der Windungen aneinander definierten Federweg verlängert, so dass der Bereich der Abstände zwischen Trägerplatte und Abdeckplatte, bei dem die Druckfeder eingesetzt werden kann entsprechend vergrößert ist. Dies führt dazu, dass bei einer Fertigung von erfindungsgemäßen Annäherungs- bzw. Berührungsschalter weniger verschiedene Typen der Druckfeder produziert bzw. auf Lager gehalten werden müssen, wodurch sich die Herstellungskosten reduzieren.

Vorzugsweise weist die Druckfeder an ihrem unteren Ende eine Lage- und/oder Verdrehsicherung auf, die insbesondere durch eine angeformte Lötöse und/oder einen angeformten Lötstift gebildet ist. Auf diese Weise kann die Druckfeder mit ihrem unteren Ende auf einfache Art und Weise mit dem elektrisch leitenden Kontakt der Trägerplatte verlötet werden.

Vorteilhafterweise weist die Druckfeder an ihrem unteren Ende zumindest eine an der Trägerplatte anliegende untere Windung auf. Die Druckfeder ist, insbesondere mit ihrer unteren Windung, an mindestens drei Orten mit dem elektrisch leitenden Kontakt galvanisch verbunden. Dies bringt den Vorteil mit sich, dass die Druckfeder für einen Lötprozess eine stabile Lage auf der Trägerplatte einnehmen kann. Auf diese Weise kann zum einen eine mechanisch spannungsfreie Lötverbindung erzielt und zum anderen die unteren Windung in Form einer SMD-Lötverbindung mit der Trägerplatte verlötet werden. Somit ist es möglich eine Bestückung der Trägerplatte mit einer oder mehreren derart ausgebildeten Druckfedern auf einfache Weise zu automatisieren. Insbesondere weist die Druckfeder an ihrem unteren Enden mindestens zwei Windungen auf, die spiralförmig in einer Ebene liegen. Durch eine zunehmende Anzahl an solchen Windungen wird die Benetzungsfläche der Druckfeder vergrößert, die in Lötprozess mit Lotpaste benetzt wird, so dass die Standfestigkeit der Druckfeder auf der Trägerplatte im Lötprozess erhöht wird.

In einer bevorzugten Ausführungsform ist auf der Trägerplatte innerhalb eines durch die Sensorfläche definierten Bereichs, insbesondere innerhalb der Druckfeder, ein Leuchtelement, wie beispielsweise eine LED, eine Glühlampe oder ein Lichtleiter, angeordnet. Dieses Leuchtelement kann zur Kennzeichnung der Sensorfläche oder zur Signalisierung verschiedener Schaltzustände des Annäherungs- und/oder Berührungsschalter dienen.

Anhand von Zeichnungen wird die Erfindung nachstehend näher erläutert.
- Fig. 1: zeigt in einer schematischen Schnittansicht einen erfindungsgemäßen kapazitiven Annäherungs- und/oder Berührungsschalter,
- Fig. 2: zeigt in einer schematischen Seitenansicht eine erste Ausführungsform einer erfindungsgemäßen Druckfeder,
- Fig.3: zeigt in einer schematischen Seitenansicht eine zweite Ausführungsform einer erfindungsgemäßen Druckfeder,
- Fig. 4: zeigt in einer schematischen Seitenansicht eine dritte Ausführungsform einer erfindungsgemäßen Druckfeder.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungs- und/oder Berührungsschalters gemäß der Erfindung in sämtlichen Zeichnungsfiguren durch gleiche Bezugszeichen bezeichnet sind.

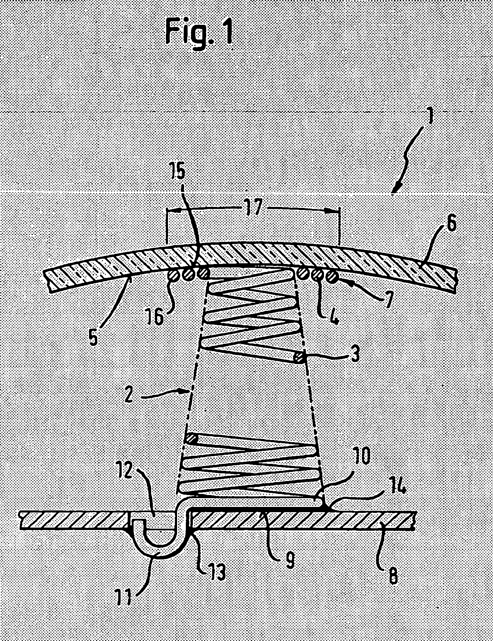

In Fig. 1 ist in einer schematischen Schnittansicht ein erfindungsgemäßer Annäherungs- und/oder Berührungsschalter gezeigt. Der Schalter 1 enthält als elektrisch leitfähigen Körper eine gewundene Druckfeder 2, die vorzugsweise aus Federdraht ausgebildet ist. Dieser Federdraht hat bevorzugt einen runden Querschnitt 3, wobei aber auch andere Querschnittsformen möglich sind, wie beispielsweise ein Oval oder ein Vieleck. Die Druckfeder 2 weist an ihrem oberen Ende mehrere Windungen 4 auf, die an einer Unterseite 5 einer gewölbten, elektrisch isolierenden Abdeckplatte 6 formschlüssig und unter einer Druckspannung anliegen. Diese Windungen liegen spiralförmig ineinander und bilden auf diese Weise einen flachen Windungsteller 7, der sich unter der Federspannung an die Wölbung der Abdeckplatte 6 elastisch anpasst. Die Abdeckplatte 6 kann aus einem Dielektrikum, wie beispielsweise Glas, Glaskeramik oder Kunststoff bestehen. In Abstand von der Abdeckplatte 6 ist eine Trägerplatte 8 mit einer der Unterseite 5 der Abdeckplatte 6 zugewandten elektrisch leitfähigen Kontaktfläche 9 angeordnet. Die Trägerplatte 8 kann eine Kunststoffplatte sein, die auf wenigstens einer ihrer Plattenseiten die erwähnte Kontaktfläche 9 und gegebenenfalls Leiterbahnen aufweist, über die die Kontaktfläche 9 mit einer Auswerteschaltung (nicht gezeigt) elektrisch verbunden ist. Die Druckfeder 2 weist an ihrem unteren Ende eine untere Windung 10 auf, mit der sie an der Kontaktfläche 9 der Trägerplatte 8 plan anliegt. An dem unteren Ende der Druckfeder 2 ist als Lage- und/oder Verdrehsicherung eine Lötöse 11 angeformt, die durch ein Loch 12 der Trägerplatte 8 hindurch ragt. Die Lötöse 11 ist durch eine Schwall-Lötverbindung 13 und die untere Windung 10 durch eine SMD-Lötverbindung 14 mit der Trägerplatte 8 verbunden. Zwischen der unteren Windung 10 und dem Windungsteller 7 ist die Druckfeder 2 keglig in Form eines Kegelstumpfes ausgebildet, wobei der Windungsdurchmesser von der unteren Windung 10 bis zum Windungsteller 7 abnimmt.

Durch die an der Unterseite 5 der Abdeckplatte anliegenden oberen Windungen 4 des Windungstellers 7 ist eine Sensorfläche 15 bestimmt, die durch eine äußere Windung 16 der oberen Windungen 4 begrenzt ist. Insbesondere liegt die äußere Windung 16 vollständig an der Unterseite 5 der Abdeckplatte 6 an. Wird nun ein Element, wie beispielsweise ein Finger, das bzw. der ein vom Potenzial der Kontaktfläche 9 der Trägerplatte 8. verschiedenes Potenzial, insbesondere Erdpotenzial führt, an einen der Sensorfläche 15 gegenüberliegenden Oberflächenbereich 17 der Abdeckplatte 6 angenähert und/oder mit diesem in Berührung gebracht, so wird dadurch eine Kapazitätsänderung eines aus dem betreffenden Element bzw. dem Finger, der Abdeckplatte und der Sensorfläche 15 bestehenden Kondensators hervorgerufen. Da die Sensorfläche 15 elektrisch leitend mit der Kontaktfläche 9 der Trägerplatte 8 und diese wiederum mit der Auswerteschaltung verbunden ist, kann die Kapazitätsänderung durch die Auswerteschaltung festgestellt und ausgewertet werden. Des weiteren kann auf der Trägerplatte 8 im Bereich innerhalb der Druckfeder 2 eine Lichtquelle (nicht gezeigt), wie beispielsweise eine LED, vorgesehen sein, um die Sensorfläche 15 zu kennzeichnen oder unterschiedliche Schaltzustände des Schalters 1 zu signalisieren. An der Oberfläche der Abdeckplatte 6 kann darüber hinaus eine elektrisch leitfähige Schicht aufgebracht sein (nicht gezeigt), um bei Berührung bzw. Annäherung eine gleichmäßige Potenzialverteilung in dem der Sensorfläche 15 gegenüberliegenden Oberflächenbereich 17 zu erzeugen. Insbesondere kann sich diese elektrisch leitfähige Schicht, deren Form von der der Sensorfläche 15 verschieden sein kann, auch über den Oberflächenbereich 17 hinaus erstrecken, so dass der Bereich vergrößert wird, in dem der Annäherungs- bzw. Berührungsschalter betätigt werden kann. Diese elektrisch leitfähige Schicht kann wiederum mit einer dielektrische Schutzschicht überzogen sein (nicht gezeigt), um eine Beschädigung der elektrisch leitfähigen Schicht zu verhindern und/oder um die Position des Annäherungs- bzw. Berührungsschalter zu kennzeichnen.

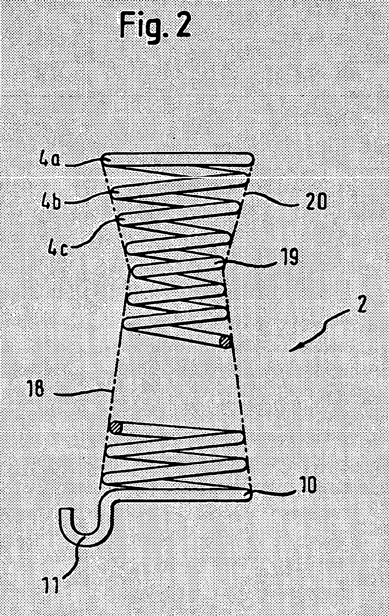

In Fig. 2 ist eine schematische Seitenansicht einer ersten Ausführungsform der erfindungsgemäßen Druckfeder 2 gezeigt. Die schraubenförmig gewundene Druckfeder 2 weist einen unteren Teilbereich 18 in Form eines Kegelstumpfes auf, bei dem der Windungsdurchmesser von der unteren Windung 10 aus nach oben bis zu einer Grenzwindung 19 abnimmt. Daran schließt sich ein oberer Teilbereich 20 ebenfalls in Form eines Kegelstumpfes an, bei dem nun allerdings der Windungsdurchmesser von der Grenzwindung 19 bis zur obersten Windung 4a wieder zunimmt. Wird die Druckfeder 2 unter Druckspannung zwischen der Abdeckplatte 6 und der Trägerplatte 8 gemäß Figur 1 montiert, so wird der obere Teilbereich 20 derart gestaucht, dass sich die obersten Windungen 4a, 4b und 4c spiralförmig ineinander schieben. Auf diese Weise wird der Windungsteller 7 entsprechend Fig. 1 gebildet, bei dem die oberen Windungen 4a, 4b und 4c an der Unterseite 5 der Abdeckplatte formschlüssig anliegen. Es ist alternativ aber auch möglich, bei der noch nicht unter Druckspannung stehenden Druckfeder 2 anschließend an die Grenzwindung 19 den Windungsteller 7 direkt anzuformen.

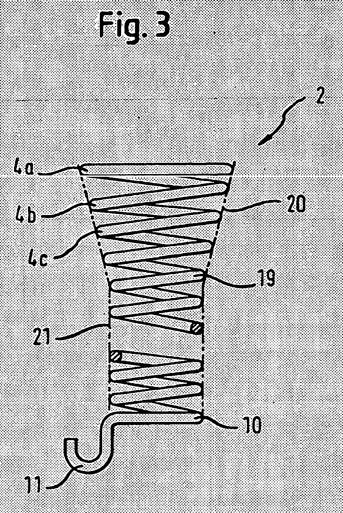

In Fig. 3 ist eine schematische Seitenansicht einer zweiten Ausführungsform der erfindungsgemäßen Druckfeder 2 gezeigt. Die schraubenförmig gewundene Druckfeder 2 weist in diesem Fall einen unteren Teilbereich 21 in Form eines Zylinders auf, bei dem der Windungsdurchmesser von der unteren Windung 10 aus bis zu der Grenzwindung 19 gleich bleibt. Daran schließt sich der oberer Teilbereich 20 in Form eines Kegelstumpfes an, bei dem nun allerdings der Windungsdurchmesser von der Grenzwindung 19 bis zur obersten Windung 4a zunimmt, so dass bei Montage der Druckfeder 2 zwischen der Abdeckplatte 6 und der Trägerplatte 8 unter Druckspannung wieder der Windungsteller 7 gebildet werden kann.

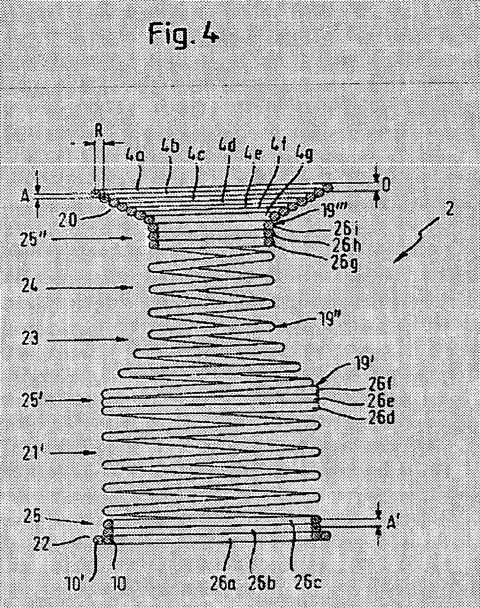

In Fig. 4 ist eine schematische Seitenansicht einer dritten Ausführungsform der erfindungsgemäßen Druckfeder 2 gezeigt. Die schraubenförmig gewundene Druckfeder 2 weist in diesem Fall an ihrem unteren Ende 22 zwei untere Windungen 10, 10' auf, die spiralförmig in einer Ebene liegen und auf diese Weise eine stabile Auflage der Druckfeder 2 auf der Trägerplatte 8 gewährleisten. Diese unteren Windungen 10, 10' werden bei dem Lötprozess mit Lotpaste benetzt und beispielsweise in Form einer SMD-Lötverbindung mit der Trägerplatte, die insbesondere eine Leiterplatte sein kann, verlötet. Ausgehend von der unteren Windung 10 weist die Druckfeder 2 analog zu Fig. 3 einen ersten Teilbereich 21' in Form eines Zylinders auf, bei dem der Windungsdurchmesser von der unteren Windung 10 aus bis zu einer ersten Grenzwindung 19' gleich bleibt. Daran schließt sich ein Übergangsbereich 23 in Form eines Kegelstumpfes an, bei dem nun allerdings der Windungsdurchmesser von der Grenzwindung 19' bis zu einer zweiten Grenzwindung 19" abnimmt. An die Grenzwindung 19" schließt sich ein zweiter Teilbereich 24 in Form eines Zylinders an, bei dem der Windungsdurchmesser von der zweiten Grenzwindung 19" bis zu einer dritten Grenzwindung 19''' gleich bleibt. Der Windungsdurchmesser des zweiten Teilbereichs 24 ist somit geringer als der Windungsdurchmesser des ersten Teilbereichs 21'. An die zweiten Teilbereich 24 schließt sich analog zu Fig. 2 der obere Teilbereich 20 in Form eines Kegelstumpfes an, bei dem der Windungsdurchmesser von der Grenzwindung 19''' bis zur obersten Windung 4a wieder zunimmt und der bei unter Druck stehender Druckfeder 2 den Windungsteller 7 bildet.

Die Windungen 4a bis 4g des oberen Teilbereichs sind derart eng gewickelt, dass zwischen je zwei benachbarten Windungen ein axialer Abstand A in Richtung der axialen Federausdehnung von einem halben Federdrahtdurchmesser D und ein radialer Abstand R in Richtung der radialen Federausdehnung von einem ganzen Federdrahtdurchmesser D besteht. Dabei wird der Abstand zwischen zwei Windungen jeweils von ihren Mittelpunkten aus gemessen. Bei unter Druckspannung stehender Druckfeder 2 bildet sich somit ein geschlossener Windungsteller 7 aus, bei dem sich benachbarte Windungen der Windungen 4a bis 4g berühren. Der erste zylindrische Teilbereich 21' weist an seinem unteren Ende einen ersten Unterteilbereich 25 mit drei Windungen 26a, 26b und 26c und an seinem oberen Ende einen zweiten Unterteilbereich 25' mit drei Windungen 26d, 26e und 26f auf, die jeweils derart eng gewickelt sind, dass zwischen je zwei benachbarten Windungen ein axialer Abstand A' in Richtung der axialen Federausdehnung von einem Federdrahtdurchmesser D besteht, d.h. die benachbarten Windungen 26a und 26b, 26b und 26c, 26d und 26e, 26e und 26f berühren sich jeweils, so dass in den Unterteilbereichen 25 und 25' die Druckfeder 2 keine Federwirkung hat. Durch diese eng nebeneinanderliegenden Windungen 4a bis 4g, 26a bis 26c und 26d bis 26f wird ein Verhaken von gleichartigen Druckfedern 2 miteinander bei einem automatisierten Bestückungsprozess verhindert, da der Abstand zwischen je zwei benachbarten Windungen der Windungen 4a bis 4g, 26a bis 26c und 26d bis 26f geringer ist als der Federdrahtdurchmesser D.

Der zweite zylindrische Teilbereich 24 weist an seinem oberen Ende einen dritten Unterteilbereich 25" mit drei Windungen 26g, 26h und 26i auf, die ebenfalls jeweils derart eng gewickelt sind, dass zwischen je zwei benachbarten Windungen ein axialer Abstand A' in Richtung der axialen Federausdehnung von einem Federdrahtdurchmesser D besteht, d.h. die benachbarten Windungen 26g und 26h bzw. 26h und 261 berühren sich jeweils, so dass in dem dritten Unterteilbereichen 25" die Druckfeder 2 keine Federwirkung hat. Durch diese eng nebeneinanderliegenden Windungen 26g bis 26i wird ein Führungszylinder für ein Bestückungswerkzeug gebildet, so dass eine automatische Bestückung der Trägerplatte mit einer oder mehreren Druckfedern 2 möglich ist.

Insgesamt ist die Druckfeder 2 einstückig aus metallischem Federdraht gewickelt. Es ist aber auch möglich die Druckfeder 2 aus anderen elektrisch leitfähigen Materialien, wie beispielsweise elektrisch leitfähigen Kunststoff oder Kunststoff mit metallischer Seele, in Form eines Kunststoffspritzlings herzustellen. Die Druckfeder 2 weist bevorzugt kreisförmige Windungen auf, aber es sind auch diverse andere Formen möglich, wie beispielsweise Ovale, Ellipsen oder Vielecke.

### Bezugszeichenliste

- 1: Annäherungs- und/oder Berührungsschalter
- 2: gewundene Druckfeder
- 3: Querschnitt des Federdrahts
- 4: obere Windungen der Druckfeder
- 5: Unterseite der Abdeckplatte
- 6: Abdeckplatte
- 7: Windungsteller
- 8: Trägerplatte
- 9: elektrisch leitfähige Kontaktfläche
- 10: untere Windung
- 11: Lötöse
- 12: Loch der Trägerplatte
- 13: Schwall-Lötverbindung
- 14: SMD-Lötverbindung
- 15: Sensorfläche
- 16: äußere Windung der oberen Windungen
- 17: Oberflächenbereich der Abdeckplatte
- 18: unterer Teilbereich
- 19: Grenzwindung
- 20: oberer Teilbereich
- 21: unterer bzw. erster Teilbereich
- 22: unteres Ende der Druckfeder
- 23: keglig geformter Übergangsbereich
- 24: zweiter Teilbereich
- 25: Unterteilbereich
- 26: Wicklung des Unterteilbereichs
- A: axialer Abstand zwischen zwei Windungen
- R: radialer Abstand zwischen zwei Windungen
- D: Federdrahtdurchmesser

## Patentansprüche

1. Kapazitiver Annäherungs- und/oder Berührungsschalter, mit einem elektrisch leitfähigen Körper, der zwischen einer elektrisch isolierenden Abdeckplatte (6) und einer im Abstand von dieser angeordneten Trägerplatte (8) angeordnet und in Abstandsrichtung elastisch verformbar ist, wobei der elektrisch leitfähige Körper mit seinem oberen Ende an der Unterseite (5) der Abdeckplatte (6) anliegt und dort eine Sensorfläche (15) bildet und wobei der elektrisch leitfähige Körper mit seinem unteren Ende mit einem elektrisch leitenden Kontakt (9) der Trägerplatte (8) verbunden ist, wobei der elektrisch leitfähige Körper eine aus einem gestreckten Körper gewundene Druckfeder (2) ist, **dadurch gekennzeichnet, dass** die Druckfeder (2) an ihrem oberen Ende mindestens zwei Windungen (4) aufweist, mit denen sie an der Unterseite (5) der Abdeckplatte (6) anliegt, dass die Windungen (4) derart spiralförmig ineinander liegen, so dass ein Windungsteller (7) ausgebildet ist, und dass der Windungsteller (7) mit seinen Windungen (4) die Sensorfläche (15) bildet.

2. Schalter nach Anspruch 1, **dadurch gekennzeichnet, dass** die Druckfeder (2) zwischen der Abdeckplatte (6) und der Trägerplatte (8) unter Druckspannung steht, und dass die Druckfeder (2) an ihrem oberen Ende eine Form aufweist, die formschlüssig an die Unterseite (5) der Abdeckplatte (6) angepasst ist.

3. Schalter nach Anspruch 1 oder 2, **dadurch gekennzeichnet, dass** die Druckfeder (2) zumindest in einem oberen Teilbereich (20) und/oder unteren Teilbereich (18) derart keglig geformt ist, dass die Druckfeder (2) Windungen (4a, 4b, 4c) mit unterschiedlichen Windungsdurchmessern aufweist.

4. Schalter nach Anspruch 3, **dadurch gekennzeichnet, dass** in dem oberen Teilbereich (20) und/oder unteren Teilbereich (18) zwischen zumindest zwei benachbarten Windungen (4a-4g) ein axialer Abstand (A) in Richtung der axialen Federausdehnung besteht, der im Bereich zwischen Null und einer Querschnittsflächenabmessung (D) des gestreckten Körpers in Richtung der axialen Federausdehnung liegt, und ein radialer Abstand (R) in Richtung der radialen Federausdehnung besteht, der im Bereich zwischen einer und einer anderthalbfachen Querschnittsflächenabmessung (D) des gestreckten Körpers in Richtung der radialen Federausdehnung liegt.

5. Schalter nach einem der vorhergehenden Ansprüche, **dadurch gekennzeichnet, dass** die Druckfeder (2) zumindest in einem Teilbereich (21, 21', 24) zylindrisch geformt ist.

6. Schalter nach Anspruch 5, **dadurch gekennzeichnet, dass** der zylindrische Teilbereich (21', 24) zumindest an einem seiner Enden einen Unterteilbereich (25, 25', 25") aufweist in dem zwischen zumindest zwei aufeinanderfolgenden Windungen (26a-26g) ein axialer Abstand (A') in Richtung der axialen Federausdehnung besteht, der kleiner ist als zwei Querschnittsflächenabmessung (D) des gestreckten Körpers in Richtung der axialen Federausdehnung.

7. Schalter nach Anspruch 6, **dadurch gekennzeichnet, dass** der Unterteilbereich (25, 25') an einem Ende des zylindrischen Teilabschnitts (21') angeordnet ist, an dem sich ein Bereich (23) mit einem geringeren Windungsdurchmesser anschließt oder der ein Endabschnitt (25) der Druckfeder (2) an sich ist.

8. Schalter nach einem der Ansprüche 5 bis 7, **dadurch gekennzeichnet, dass** die Druckfeder (2) in einem ersten Teilbereich (21') und in einem zweiten Teilbereich (24) derart zylindrisch geformt ist, dass der erste Teilbereich (21') einen von dem zweiten Teilbereich (24) verschiedenen Windungsdurchmesser aufweist, und dass zwischen dem ersten Teilbereich (21') und dem zweiten Teilbereich (24) ein keglig geformter Übergangsbereich (23) angeordnet ist.

9. Schalter nach einem der vorhergehenden Ansprüche, **dadurch gekennzeichnet, dass** die Druckfeder (2) an ihrem unteren Ende eine Lage- und/oder Verdrehsicherung (11, 13, 14) aufweist.

10. Schalter nach Anspruch 9, **dadurch gekennzeichnet, dass** die Lage- und/oder Verdrehsicherung durch eine angeformte Lötöse (11) und/oder einen angeformten Lötstift gebildet ist.

11. Schalter nach einem der vorhergehenden Ansprüche, **dadurch gekennzeichnet, dass** die Druckfeder (2) an ihrem unteren Ende zumindest eine an der Trägerplatte (8) anliegende untere Windung (10) aufweist, und an mindestens drei Orten mit dem elektrisch leitenden Kontakt (9) galvanisch verbunden ist.

12. Schalter nach einem der vorhergehenden Ansprüche, **dadurch gekennzeichnet, dass** auf der Trägerplatte (8) innerhalb eines durch die Sensorfläche (15) definierten Bereichs ein Leuchtelement angeordnet ist.

13. Schalter nach Anspruch 12, **dadurch gekennzeichnet, dass** das Leuchtelement innerhalb der Druckfeder (2)angeordnet ist.

14. Druckfeder für einen- kapazitiven Annäherungs- und/oder Berührungsschalter gemäß einem der Ansprüche 1 bis 10.

## Claims

1. Capacitive proximity and/or contact switch, with an electrically conductive body which is arranged between an electrically insulating cover plate (6) and a carrier plate (8) arranged at a spacing therefrom and which is resiliently deformable in the direction of spacing, wherein the electrically conductive body bears by its upper end against the underside (5) of the cover plate (6) and forms a sensor surface (15) there and wherein the electrically conductive body is connected by its lower end with an electrically conductive contact (9) of the carrier plate (8), wherein the electrically conductive body is a compression spring (2) wound from a stretched body, **characterised in that** the compression spring (2) has at least upper end at least two windings (4) by which it bears against the underside (5) of the cover plate (6), that the windings (4) lie spirally one in the other in such a manner that a winding plate (7) is formed and that the winding plate (7) forms the sensor surface (15) by its windings (4).

2. Switch according to claim 1, **characterised in that** the compression spring (2) is disposed under compressive stress between the cover plate (6) and the carrier plate (8) and that the compression spring (2) has at its upper end a shape which is matched in shape-locking manner to the underside (5) of the cover plate (6).

3. Switch according to claim 1 or 2, **characterised in that** the compression spring (2) is conically shaped at least in an upper part region (20) and/or lower part region (18) in such a manner that the compression spring (2) has windings (4a, 4b, 4c) with different winding diameters.

4. Switch according to claim 3, **characterised in that** present in the upper part region (20) and/or lower part region (18) between at least two adjacent windings (4a-4g) and in the direction of the axial spring extent is an axial spacing (A) which lies in the range between zero and a cross-sectional area dimension (D) of the stretched body in the direction of the axial spring extent, and present in the direction of the radial spring extent is a radial spacing (R) which lies in the range between one and one-and-a-half times the cross-sectional area dimension (D) of the stretched body in the direction of the radial spring extent.

5. Switch according to any one of the preceding claims, **characterised in that** the compression spring (2) is of cylindrical form at least in a part region (21, 21', 24).

6. Switch according to claim 5, **characterised in that** the cylindrical part region (21', 24) has at least at one of its ends a sub-part region (25, 25', 25") in which there is present between at least two successive windings (26a-26g) and in the direction of the axial spring extent an axial spacing (A') which is smaller than twice the cross-sectional area dimension (D) of the stretched body in the direction of the axial spring extent.

7. Switch according to claim 6, **characterised in that** the sub-part region (25, 25') is arranged at an end of the cylindrical part section (21') at which a region (23) with a smaller winding diameter adjoins or which is an end section (25) of the compression spring (2) as such.

8. Switch according to any one of claims 5 to 7, **characterised in that** the compression spring (2) is cylindrically shaped in a first part region (21') and in a second part region (24) in such a manner that the first part region (21') has a winding diameter different from the second part region (24) and that a conically shaped transition region (23) is arranged between the first part region (21') and the second part region (24).

9. Switch according to any one of the preceding claims, **characterised in that** the compression spring (2) has a positional and/or rotational securing (11, 13, 14) at its lower end.

10. Switch according to claim 9, **characterised in that** the positional and/or rotational securing is formed by an integrally formed solder eye (11) and/or an integrally formed solder pin.

11. Switch according to any one of the preceding claims, **characterised in that** the compression spring (2) has at its lower end at least one lower winding (10) bearing against the carrier plate (8) and is electrically connected with the electrically conductive contact (9) at at least three locations.

12. Switch according to any one of the preceding claims, **characterised in that** a lighting element is arranged on the carrier plate (8) within a region defined by the sensor surface (15).

13. Switch according to claim 12, **characterised in that** the lighting element is arranged within the compression spring (2).

14. Compression spring for a capacitive proximity and/or contact switch according to any one of claims 1 to 10.

## Revendications

1. Capteur de proximité et/ou de contact capacitif, comprenant un corps conducteur électrique qui est disposé entre une plaque de recouvrement (6) isolant électriquement et une plaque de support (8) disposée à écart de celle-là, et qui est déformable élastiquement en direction de l'écart, le corps conducteur électrique étant, avec son extrémité supérieure, adjacent au côté inférieur (5) de la plaque de recouvrement (6) et y formant une surface de capteur (15), et le corps conducteur électrique étant raccordé avec son extrémité inférieure à un contact (9) conducteur électrique de la plaque de support (8), le corps conducteur électrique étant un ressort de pression (2) enroulé à partir d'un corps allongé, **caractérisé en ce que** le ressort de pression (2) présente au moins deux spires (4) sur son extrémité supérieure, avec lesquelles il est adjacent au côté inférieur (5) de la plaque de recouvrement (6), **en ce que** les spires (4) sont situées les unes dans les autres en forme de spirale de telle manière qu'un actionneur de spires (7) est formé, et **en ce que** l'actionneur de spires (7) forme la surface de capteur (15) avec ses spires (4).

2. Capteur selon la revendication 1, **caractérisé en ce que** le ressort de pression (2) est sous contrainte de compression entre la plaque de recouvrement (6) et la plaque de support (8), et **en ce que** le ressort de pression (2) présente sur son extrémité supérieure une forme qui est adaptée au côté inférieur (5) de la plaque de recouvrement (6) par conjugaison de formes.

3. Capteur selon la revendication 1 ou 2, **caractérisé en ce que** le ressort de pression (2), au moins dans une zone partielle supérieure (20) et/ou dans une zone partielle inférieure (18), est formé conique de telle manière que le ressort de pression (2) présente des spires (4a, 4b, 4c) ayant différents diamètres de spire.

4. Capteur selon la revendication 3, **caractérisé en ce que** dans la zone partielle supérieure (20) et/ou dans la zone partielle inférieure (18) un écart axial (A) existe entre au moins deux spires voisines (4a-4g) en direction de l'allongement de ressort axial, cet écart étant compris entre zéro et une dimension de la surface de section (D) du corps allongé en direction de l'allongement de ressort axial, et **en ce qu'**un écart radial (R) existe en direction de l'allongement de ressort radial, cet écart étant situé dans la plage comprise entre une dimension de la surface de la section et une dimension de la surface de section (D) d'une fois et demi du corps allongé en direction de l'allongement de ressort radial.

5. Capteur selon l'une quelconque des revendications précédentes, **caractérisé en ce que** le ressort de pression (2) est formé de manière cylindrique au moins dans une zone partielle (21, 21', 24).

6. Capteur selon la revendication 5, **caractérisé en ce que** la zone partielle cylindrique (21', 24), au moins sur l'une des ses extrémités, présente une zone secondaire (25, 25', 25") dans laquelle un écart axial (A') existe entre au moins deux spires consécutives (26a-26g) en direction de l'allongement de ressort axial, cet écart étant inférieur à deux dimensions de la surface de section (D) du corps allongé en direction de l'allongement de ressort axial.

7. Capteur selon la revendication 6, **caractérisé en ce que** la zone secondaire (25, 25') est disposée sur une extrémité de la section partielle (21') cylindrique, à laquelle se raccorde une zone (23) ayant un diamètre de spire plus petit ou qui est en soi une section terminale (25) du ressort de pression (2).

8. Capteur selon l'une quelconque des revendications 5 à 7, **caractérisé en ce que** le ressort de pression (2), dans une première zone partielle (21') et dans une seconde zone partielle (24), est formé cylindrique de telle manière que la première zone partielle (21') présente un diamètre de spire différent de la seconde zone partielle (24), et **en ce qu'**une zone de transition (23) formée de manière conique est disposée entre la première zone partielle (21') et la seconde zone partielle (24).

9. Capteur selon l'une quelconque des revendications précédentes, **caractérisé en ce que** le ressort de pression (2) présente sur son extrémité inférieure un dispositif de sécurité de position et/ou de sécurité contre la torsion.

10. Capteur selon la revendication 9, **caractérisé en ce que** le dispositif de sécurité de position et/ou de sécurité contre la torsion est formé par un oeillet à souder formé (11) et/ou par une lame à souder formée.

11. Capteur selon l'une quelconque des revendications précédentes, **caractérisé en ce que** le ressort de pression (2) présente sur son extrémité inférieure au moins une spire inférieure (10) adjacente à la plaque de support (8) et raccordée galvaniquement au contact conducteur électrique (9) à au moins trois emplacements.

12. Capteur selon l'une quelconque des revendications précédentes, **caractérisé en ce qu'** un élément lumineux est disposé sur la plaque de support (8) à l'intérieur d'une zone définie par la surface de capteur (15).

13. Capteur selon la revendication 12, **caractérisé en ce que** l'élément lumineux est disposé à l'intérieur du ressort de pression (2).

14. Ressort de pression pour un capteur de proximité et/ou de contact capacitif selon l'une quelconque des revendications 1 à 10.
